# EUROPEAN PATENT APPLICATION

(11) **EP 0 924 972 A2**
(43) Date of publication of application: **23.06.1999**
(21) Application number: 98310291.4
(22) Date of filing: 15.12.1998
(51) Int. Cl.: H05K 5/02, H01R 23/72, G06K 19/077

(54) **Socket for miniature memory card**

(30) Priority: 18.12.1997 US 993668
(71) Applicant: THE WHITAKER CORPORATION, Wilmington, Delaware 19808 (US)
(72) Inventor: Kaufman, John W., Hershey, PA 17033 (US); Kandolf, Michael P., Newsport, PA 17074 (US); Murr, Keith M., York, PA 17403 (US)
(74) Representative: Johnstone, Douglas Ian

(57) **Abstract**

A memory card socket (10) having a frame (20) adapted for connection to a peripheral device and defining a card receiving opening (23) adapted to receive a memory card (100). The socket includes a contact array (60,70) which provides a connection between the card and the peripheral device. The contact array includes a plurality of spring force contacts (60) comprising a fixed portion (78) and a coil portion (80) which is loaded upon insertion of the card. The socket further includes a release mechanism (30) which, upon actuation, allows unloading of the spring force contacts (60) and ejection of the card (100).

## Description

The present invention relates to memory cards which are used in electronic devices. More particularly, the present invention relates to a socket for a miniature memory card.

Memory cards are commonly used in various kinds of electronic equipment in the communications and computer industries. The memory cards are advantageous because they provide flash type memory; that is, they retain data without requiring a constant power supply and transfer the data through electronic components which do not require moving heads or rotating media. Originally, memory cards came in standard sizes which all had a standard footprint approximately the size of a credit card. However, with electronic equipment becoming smaller and smaller, compact and miniature memory cards, having footprints approximately the size of a matchbook, were developed.

Memory cards are generally interchangeable, and therefore, the electronic equipment must be provided with sockets which mechanically and electrically connect the memory cards to the electronic device. Prior art sockets, particularly those made for compact and miniature memory cards, are generally provided with elastomeric connectors to electronically connect the card to the electronic device. These elastomeric connectors often provide very high contact resistance. To increase the electrical contact it is often necessary to increase the pressure between the card and the elastomeric connector. However, this results in a more complex mechanical system.

The sockets must also include release mechanisms to allow removal of the memory cards. Prior art card sockets generally provide non-integral buttons, levers and latches to effectuate ejection of the card. Such mechanisms are complicated to manufacture and introduce more components which are subject to failure.

Accordingly, there is a need for a light weight, simple and reliable miniature card socket.

The present invention relates to a memory card socket adapted for connection to a peripheral electronic device. The socket generally includes a frame, a release mechanism, and a contact array. The frame defines a card receiving opening adapted to receive the memory card. The contact array includes a plurality of spring force contacts which provide a connection between the card and the peripheral device. Each spring force contact includes a fixed portion and a coil portion which is loaded upon insertion of the card. Actuation of the release mechanism allow unloading of the spring force contacts and ejection of the card.

The frame may include forward, rear and side frame members where the release mechanism is integrally formed with the rear frame member.

Embodiments of the present invention will now be described by way of example with reference to the accompanying drawings, in which:-
Figure 1 is an isometric view of the components of the card socket of the present invention and a memory card which is positioned therein;
Figure 2 is a top plan view of the socket frame of the present invention;
Figure 3 is a top plan view of a connector in accordance with the present invention;
Figure 4 is an elevation view of a connector in accordance with the present invention;
Figure 5 is an elevation view of a ground contact in accordance with the present invention;
Figure 6 is a flat pattern view of the ground contact;
Figure 7 is an elevation view of a spring contact in accordance with the
present invention;
Figure 8 is a sectional view taken along the line 8-8 in Figure 1; and
Figures 9-13 are sectional views showing the progression of a memory card being inserted and removed from the socket of the present invention.

The preferred embodiments will be described with reference to the drawing figures wherein like numerals represent like elements throughout. Reference to orientation herein is provided for clarity only and is not intended to limit the configuration or placement of the device.

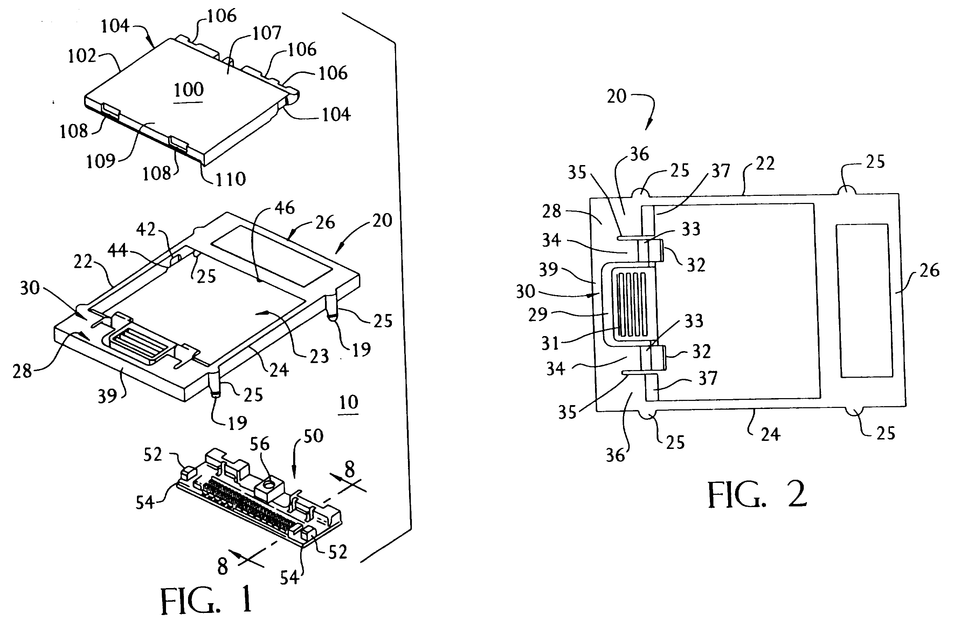

The preferred embodiment of the card socket **10** made in accordance with the present invention is shown in **Figure 1.** The socket **10** generally comprises a frame **20**, a release mechanism **30**, and a connector **50**. An exemplary memory card **100** is also shown in **Figure 1**. It generally comprises a body member **102** having a plurality of contact receptacles **104** and ground contacts **106** extending across its forward end **107** and a plurality of retainer notches **108** across its rear end **109**.

The frame **20** will be described in more detail with reference to **Figures 1** and **2**. Referring to **Figure 1**, the frame **20** includes forward and rear frame members **26** and **28** and opposed lateral frame members **22** and **24** extending therebetween. The frame members **22, 24, 26,** and **28** define a generally rectangular card receiving opening **23**. A pair of legs **25** depends from each lateral frame members **22, 24.** The legs **25** include flared portions **19** which pass through holes in the printed circuit board and connect the socket **10** thereto. Other connection means may also be used to connect the socket **10** to a circuit board, as is known in the art.

Each lateral frame member **22, 24** has a pair of integrated notches **42** and **44** which are dimensioned to receive a tab **52** and lateral edge **54** of the connector **50.** A post **46** depends from the interior surface of forward frame member **26** and is dimensioned to mate with a receiving hole **56** on the connector **50**. As such, the connector **50** is maintained in position in the frame **20** through the interference fit of the tabs **52** and lateral edges **54** in frame notches **42** and **44**, and of post **46** in receiving hole **56**.

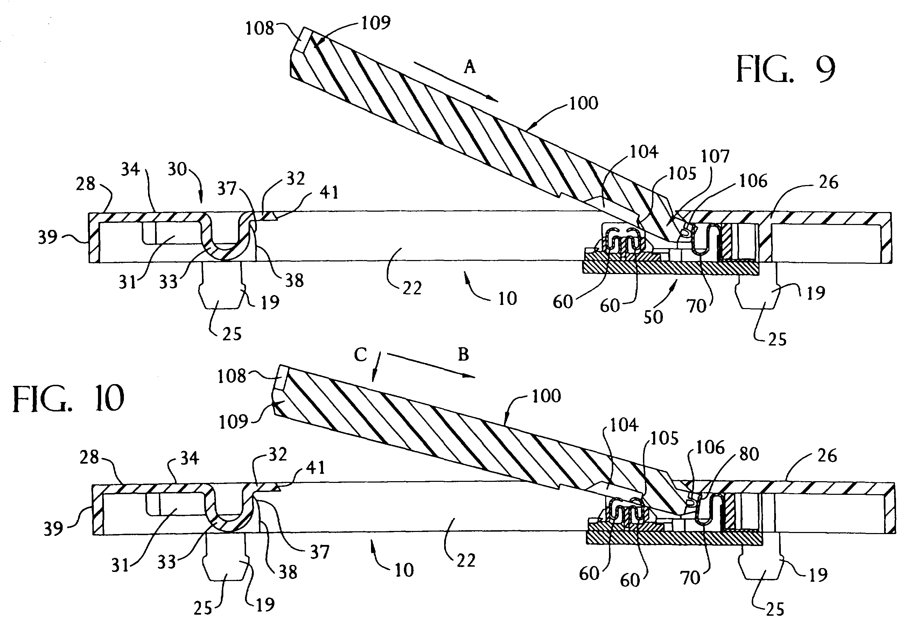

Referring to **Figure 2,** the rear frame member **28** includes a planar portion, defined by edge members **36**, extensions **34**, and a rear wall **39**. Each edge member **36** is integrally formed at the intersection between a respective lateral frame member **22, 24** and the rear wall **39.** As shown in **Figure 9**, an angular wall portion **37** and a vertical wall portion **38** depend from the forward end of each edge member **36.** Each extension **34** extends from the rear wall **39** adjacent to a respective edge member **36**. A slot **35** separates the forward portion of each extension **34** from the adjacent edge portion **36**. This allows the forward portion of each extension **34** to be flexible. The extensions **34** and rear wall **39** define an opening **29** in the rear frame member **28**.

The release mechanism **30** is formed integral with the rear frame member **28** and will be described with reference to **Figures 2** and **9**. The release member includes a pair of U-shaped return members **33.** One end of each return member **33** extends from the forward end of a respective extension **34**. The other end of the return member **33** terminates in a retention tab **32**. In the initially assembled position, as shown in **Figure 9**, the retention tabs **32** preferably extend along the same plane as extensions **34** and extend forward of vertical walls **38**. The extensions **34** and returns **33** are flexible to allow the retention tabs **32** to move rearward and downward as the card **100** is inserted, as will be described in greater detail hereinafter. A thumb pad **31** extends between the retention tabs **32** and is dimensioned to fit within opening **29**. The thumb pad **31** is depressed to automatically release the card **100**, as will be described hereinafter.

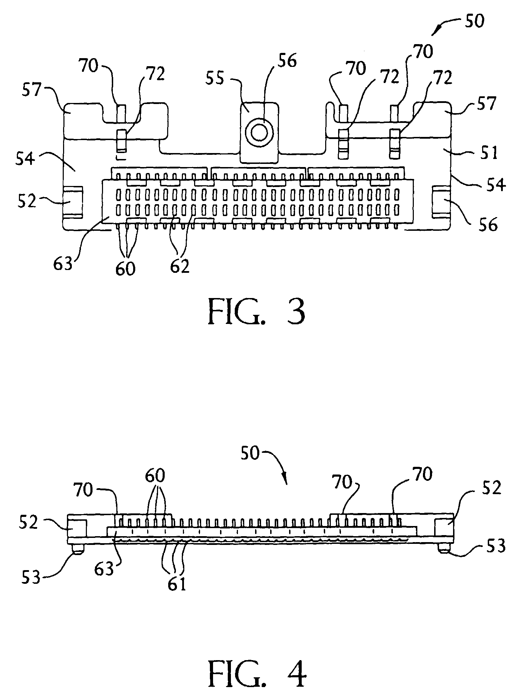

The connector **50** will now be described with reference to **Figures 3-8**. Referring specifically to **Figures 3** and **4**, the connector **50** includes an array of contacts **60,70** and includes a main body portion **51** having a width which allows tabs **52** and lateral edges **54** to be interference fit in notches **42** and **44** of each lateral frame member **22, 24** of frame **20**. Receiving hole **56** is provided in an elevated portion **55** at the forward edge of body **51** and is positioned to be aligned with frame post **46.** Additional elevated portions **57** are provided along the forward edge of body **51** adjacent to the lateral sides **54**. Elevated portions **57** have a plurality of slots **72** for receiving grounding contacts **70**. The rear edge of connector main body **51** includes a contact housing **63** which is defined by a raised portion with a plurality of spring contact receiving openings **62** extending therethrough. The underside of contact housing **63** has a plurality of slots **61** aligned with the spring contact receiving openings **62**. Each slot **61** receives and retains the lead portion **64** of a spring contact **60** when it is inserted in the opening **62**. An alignment peg **53** is preferably provided along each lateral edge **54** of body **51** to correctly position the connector **50** relative to the surface mount pads on the circuit board to which it is attached.

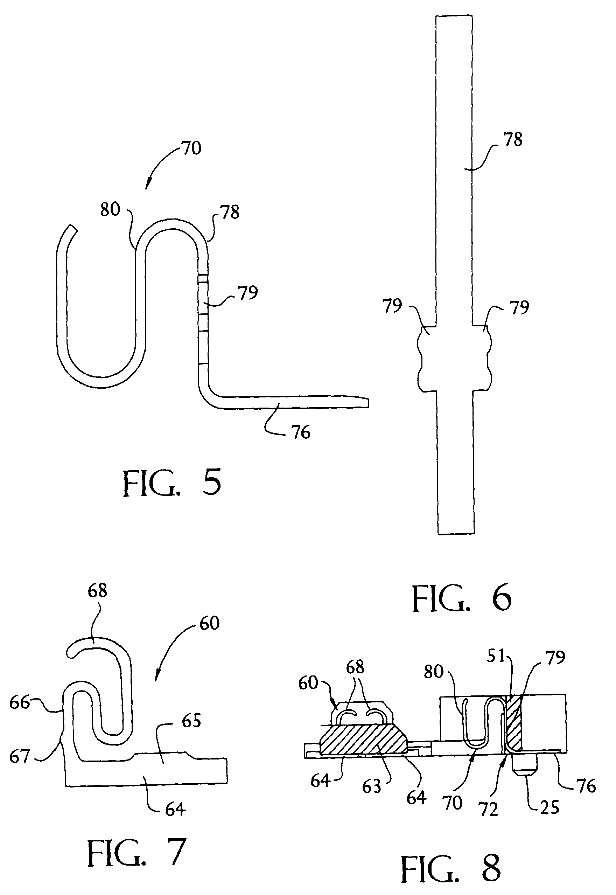

Referring to **Figures 5** and **6**, each grounding contact includes a lead portion **76**, a retention or fixed portion **78**, and a coil contact portion **80**. The grounding contacts **70** are positioned in the connector **50** with the retention portions extending through slots **72** in main body **51**, see **Figure 8**. Each retention portion **78** includes shoulders **79** extending outward therefrom which provide an interference with the slot **72** to maintain the grounding contact **70** in position. Each lead portion **76** extends below the lower plane of connector **50** whereby it makes electrical contact with grounding strips on the printed circuit board to which the socket **10** is attached. The coil contact portions **80** extend rearward of slots **72** where they are positioned to contact the card ground contacts **106.**

Referring to **Figures 7** and **8**, each spring contact **60** includes a lead portion **64**, a post **66**, and a spring portion **68**. When the spring contacts **60** are positioned in contact housing **63**, the leads **64** extend below the plane of housing **63** to allow electrical contact with the printed circuit board. Each lead **64** and post **66** is provided with a protuberance **65, 67**, respectively, which embeds in the contact housing **63** to maintain the spring contact **60** in position. The spring portion **68** provides an electrical contact to the card **100**, and also coils to provide an ejecting spring force, as will be described in more detail hereinafter. Having described the components of the socket **10**, its operation will now be described with reference to **Figures 9-13**.

As indicated by arrow **A** in **Figure 9**, the card forward end **107** is initially inserted into the card receiving opening **23** adjacent to forward frame member **26**. In this initial position shown in **Figure 9**, the card ground contacts **106** begin to contact the grounding contacts **70** of connector **50**.

The card **100** is then pushed forward and downward, as indicated by arrows **B** and **C** in **Figure 10**, whereby the card ground contacts **106** push against coil contact portion **80** of ground contact **70**. The spring force of coil contact portion **80** begins to load. At the same time, the spring contacts **60** begin to enter the card contact receptacles **104**. The receptacles **104** have a beveled front surface **105** which assists in aligning the receptacles **104** with the spring contacts **60**.

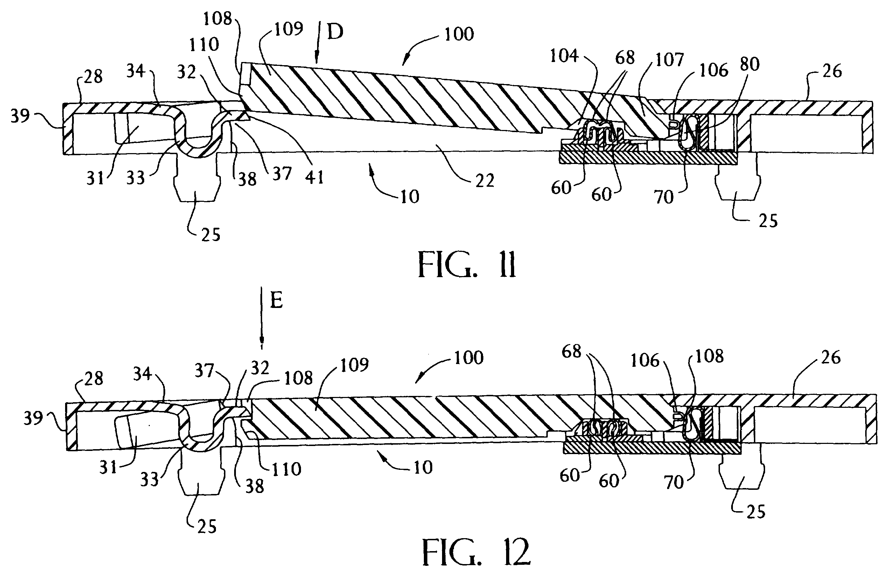

Turning to **Figure 11**, the rear portion **109** of card **100** is pushed further downward in the direction of arrow **D**. As the card rear end **109** moves downward, the front end **107** moves slightly forward, whereby card ground contacts **106** push against the connector grounding contacts **70** and coil contact portions **80** become almost completely loaded. At the same time, the card contact receptacles **104** are aligned with and contact the connector spring contacts **60**. The contact receptacles **104** begin to deflect, and thereby load, the spring portion **68** of contacts **60**. The card rear end **109** contacts the retention tabs **32** and deflects the tabs **32** and thumb pad **31** downward.

As the connector card **100** is pushed in the direction of arrow **E** in **Figure 12**, the card rear beveled portion **110** contacts the tab beveled portions **41**. This forces tabs **32** and thumb pad **31** rearward until the tabs **32** clear card rear end **109** and enter retainer notches **108**. The tabs **32** remain in contact with the retainer notches **108** and thereby maintain the card in position in the socket **10**, as shown in **Figure 12.**

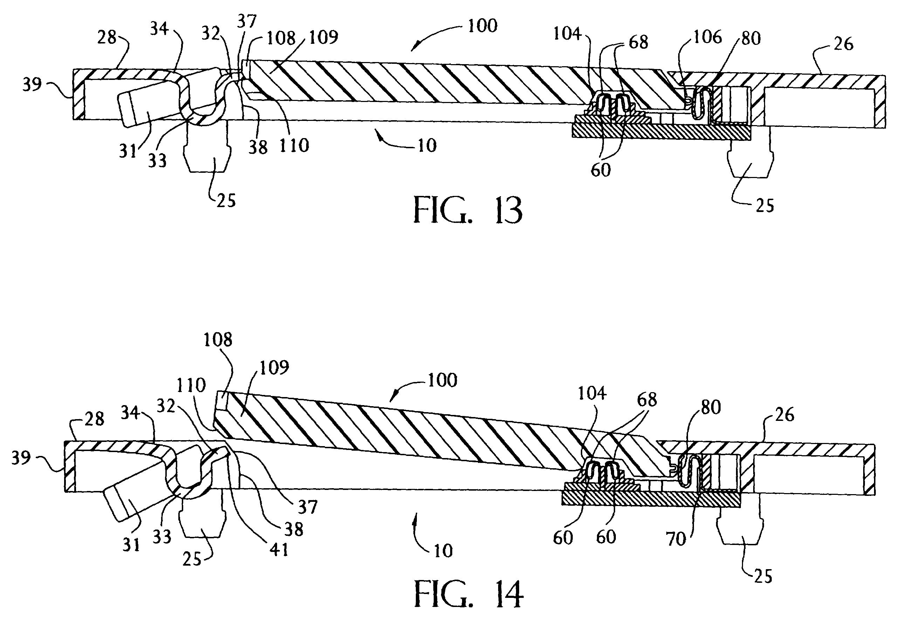

Referring to **Figure 13**, the card **100** is released by pushing downward and rearward on thumb pad **31**. In conjunction therewith, the retention tabs **32** rotate rearward and upward. As the tabs **32** release the tension on the card rear end **109**, the contact spring portions **68** and **80** begin to push the card **100** rearward and upward. The card is initially pushed rearward until the card rear end **109** contacts the frame vertical wall **38**. However, as the thumb pad **31** is depressed further and the tabs **32** move rearward and upward, as shown in **Figure 14**, the spring contact spring portions **68** push up on the card **100** until the beveled edge **110** thereof meets the rear frame angled surface **37**. At that point, the spring forces loaded in contact spring portions **68** and **80** cause the card **100** to slide along surface **37** until the card rear end **109** clears the socket **10**. The card **100** is then lifted from socket **10**.

## Claims

1. A memory card socket (10) of a type having a frame (20) adapted for connection to a peripheral device and defining a card receiving opening (23) adapted to receive a memory card (100), a release mechanism (30), and a contact array (60,70) which provides a connection between the card and the peripheral device, the contact array (60,70) including a plurality of spring force contacts (60), each spring force contact (60) including a fixed portion (78) and a coil portion (80) which is loaded upon insertion of the card (100), whereby actuation of the release mechanism (30) allows unloading of the spring force contacts (60) and ejection of the card (100).

2. The socket (10) of claim 1, wherein the frame (20) includes a rear frame member (28) which defines a rear edge of the card receiving opening (23) and the release mechanism (30) is formed integrally with the rear frame member (28).

3. A memory card socket (10) of a type having a frame (20) adapted for connection to a peripheral device and including forward (26), rear (28) and side (22,24) frame members which define a card receiving opening (23) adapted to receive a memory card (100), and a release mechanism (30) formed integrally with the rear frame member (28).

4. The socket (10) of claim 3, wherein the socket (10) comprises a contact array (60,70) including a plurality of spring force contacts (60), each spring force contact (60) including a fixed portion (78) and a coil portion (80) which is loaded upon insertion of the card (100), whereby actuation of the release mechanism (30) allows unloading of the spring force contacts (60) and ejection of the card (100).

5. The socket (10) of claim 1, 2 or 4, wherein the contact array (60,70) includes at least one grounding contact (70).

6. The socket (10) of claim 1, 2, 4 or 5, wherein the contact array (60,70) is affixed to a connector (50) associated with said frame (20).

7. The socket (10) of claim 2 or 3 or any claim dependent thereon, wherein the rear frame member (28) includes a flexible portion (34) which allows deflection of the release mechanism (30).

8. The socket (10) of claim 7, wherein the release mechanism (30) includes a retention tab (32) and a flexible return member (33) extending between the retention tab (32) and the rear frame member flexible portion (34) whereby the retention tab is movable between a deflected position which permits insertion of the card (100) into the card receiving opening (23) and a retention position which maintains the card in the socket.

9. The socket (10) of claim 8, wherein the release mechanism (30) includes a pad member (31) associated with the retention tab (32) whereby depression of the pad member (31) moves the retention tab (32) from the retention position to an ejection position which allows removal of the card from the socket.
